# EUROPEAN PATENT APPLICATION

(11) **EP 1 932 725 A1**
(43) Date of publication of application: **18.06.2008**
(21) Application number: 06768297.1
(22) Date of filing: 19.07.2006
(51) Int. Cl.: B60R 11/02, B60R 16/02, G06F 3/041, G09F 9/00, G09G 5/00

(54) **DATA PROCESSING DEVICE**

(30) Priority: 07.10.2005 JP 2005294814
(71) Applicant: MATSUSHITA ELECTRIC INDUSTRIAL CO., LTD., Osaka 571-8501 (JP)
(72) Inventor: SATOU, Makoto c/o Matsuhita Ind. Co., Ltd., Osaka-shi, Osaka 540-6207 (JP)
(74) Representative: Pautex Schneider, Nicole Véronique
(86) International application number: PCT/JP2006/314271
(87) International publication number: WO 2007/043229

(57) **Abstract**

The present invention is for solving a problem of the disability to distinguish operations executed by a plurality of users while the users are caused to visually ascertain different images. A HDD 12 stores a program for causing a CPU 14 to execute driver seat processing as processing corresponding to presence coordinates (x(k),y(k)) of an object when the presence direction of the object determined on the basis of detection values of the proximity sensors 5 is the direction to the driver seat and passenger seat processing as processing corresponding to the presence coordinates (x(k), y(k)) of the object when the presence direction of the object is the direction to the passenger seat. The HDD 12 also stores driver seat operation item data, passenger seat operation item data, a driver seat operation table, a passenger seat operation table, and the like.

## Description

### Technical Field

The present invention relates to a data processor, and more particularly to an audiovisual system, a navigation system, and the like.

### Background Art

A car navigation system, which is known as a background art, is comprised of a display device, a neck section, and a controller. The display device simultaneously displays different screens from a single display area to a plurality of directions. The neck section holds the display device pivotally. The controller switches operation executed by a command from a remote controller, depending on the position of the display device. This system is described in paragraphs from 0029 to 0031 and Fig. 9 in Patent Document 1 (JP-A-2005-91475).

### Disclosure of the Invention

### Problem to be solved in the invention

According to the description in Patent Document 1, the operation, to be executed, switches depending on the display device position. Therefore, the display area of the display device faces to a driver for enabling the driver to execute operation by the remote controller. At this time, a passenger in a passenger seat cannot view the display area of the display. In short, while the driver or the passenger executes the operation by the remote controller, it is meaningless that the display device simultaneously displays different screens from a single display area to a plurality of directions.

### Means for Solving the Problem

The present invention relates to a data processor. The data processor connects to a display device and to a coordinate sensor. The display device can display a first image and a second image respectively to a first direction and a second direction. The coordinate sensor outputs a detection value corresponding to a coordinate of an object being above a display area of the display device. The data processor has a control section. The control section executes a first direction process depending on the detection value of the coordinate sensor if a presence direction of the object is the first direction. The control section executes a second direction process depending on the detection value of the coordinate sensor if the presence direction is the first direction. The presence direction is determined on the basis of the detection value of the sensor. This sensor is placed around the display area. Languages employed in the present invention are construed as follows.

The "display device" is implemented with a so-called liquid crystal display of view angle control type (see JP-A-8-136909, JP-A-2002-99223, and the like).

A relationship between "first direction" and "second direction" includes a relationship between the "direction to a driver seat" and the "direction to a passenger seat," a relationship between a "rightward direction" and a "leftward direction," and the like.

The "object" generally implies a tangible thing:, a body (fingers, arms, and the like), pens, styluses, and others.

The language "coordinate sensor" includes a touch sensor and a non-contact sensor. The touch sensor is implemented with a resistive film touch panel, an electrostatic capacitance touch panel, and the like. The non-contact sensor is implemented with an infrared touch panel, and the like.

The expression "placed around the display area" implies that the sensor (or the sensors) require(s) to locate around the display area is required and it is not limited whether or not the sensor is embedded in the display device.

The language "sensor" includes a contact sensor and a non-contact sensor. The "contact sensor" is a sensor that outputs a detection value in response to a contact. For instance, a pressure sensor, and the like, is available. The "non-contact sensor" is a sensor that emits a detection medium to a target of detection and receives the reflected detection medium, to output a detection value. For instance, a pulse sensor, an infrared sensor, and the like, is available.

The language "detection value" includes a logical value and a numeral value. The "logical value" mainly indicates either whether or not an object contacts to the display device or whether or not a distance between the display device and the object matches a predetermined value. The "numeral value" is a value corresponding to a distance between the display device and the object.

The expression "determined from the detection values" implies that it is not limited whether or not a subject to be determined is a data processing device.

The language "determined" includes a determination made through arithmetic processing and a determination made through table processing.

The "presence direction of the object" is a direction that points from a position where the display device (or the display area) exists to a position where the object approaching the display device (or the display area) exists. The language "approaching" includes that: the object contacts to the display device, and a distance between the display device and the object comes into the range of a predetermined value.

The "control section" implements control operation by hardware or by synergistic operation of hardware and software.

The "control section" preferably executes the first direction processing as a processing corresponding to an object presence coordinate P(k)if the presence direction is the first direction. The control section executes the second direction processing as a processing corresponding to the object presence coordinate P(k) if the presence direction is the second direction.

It is not limited whether or not the "data processing device" is mounted on a vehicle. In particular, when the "data processing device" is mounted on a vehicle, the processing device corresponds to a "vehicle-mounted data processing device."

### Advantage of the Invention

The present invention has an advantage that user operations can be distinguished from each other even though a user in the first direction and a user in the second direction can watch different images, because: the first direction processing is executed depending on a detection value of the coordinate sensor if the presence direction is the first direction; and the second direction processing is executed depending on the detection value if the presence direction is the second direction.

### Brief Description of the Drawings

Fig. 1 is a hardware block diagram showing a configuration in the best mode for implementing a data processing device of the present invention.
Fig. 2 is a view showing a relationship among a liquid-crystal display, a driver seat, and a passenger seat.
Fig. 3 is a view showing a positional relationship between the liquid-crystal display and a proximity sensor.
Fig. 4 is a view showing a direction in which a detection medium is emitted from the proximity sensor.
Fig. 5 is a block diagram showing the configuration of the proximity sensor.
Fig. 6 is a view showing a relationship between a distance of proximity and a detection value acquired by the proximity sensor.
Fig. 7 is a flowchart showing the flow of storage processing.
Fig. 8 is a diagram showing a relationship among the proximity sensor, a port address, and a storage area.
Fig. 9 is a flowchart showing the flow of operation-related processing.
Fig. 10 is a view showing an expansion area for operation item data in VRAM.
Fig. 11 (a) is a view showing specifics of an operation table for the driver seat, and Fig. 11(b) is a view showing specifics of an operation table for the passenger seat.
Fig. 12(a) is a view showing approaching of an object from the direction to the driver seat, and Fig. 12(b) a view showing an example display of operation items achieved in the case of Fig. 12(a).
Fig. 13(a) is a view showing approaching of an object from the direction to the passenger seat, and Fig. 13(b) is a view showing an example display of operation items achieved in the case of Fig. 13(a).

### Descriptions of the Reference Numerals

- 2: LIQUID-CRYSTAL DISPLAY (DISPLAY DEVICE)
- 2a: DISPLAY AREA
- 3: NAVIGATION SYSTEM (DATA PROCESSING DEVICE)
- 5: PROXIMITY SENSOR (SENSOR)
- 7: TOUCH PANEL (COORDINATE SENSOR)
- 14: CPU (CONTROL SECTION)

### Best Mode for Implementing the Invention

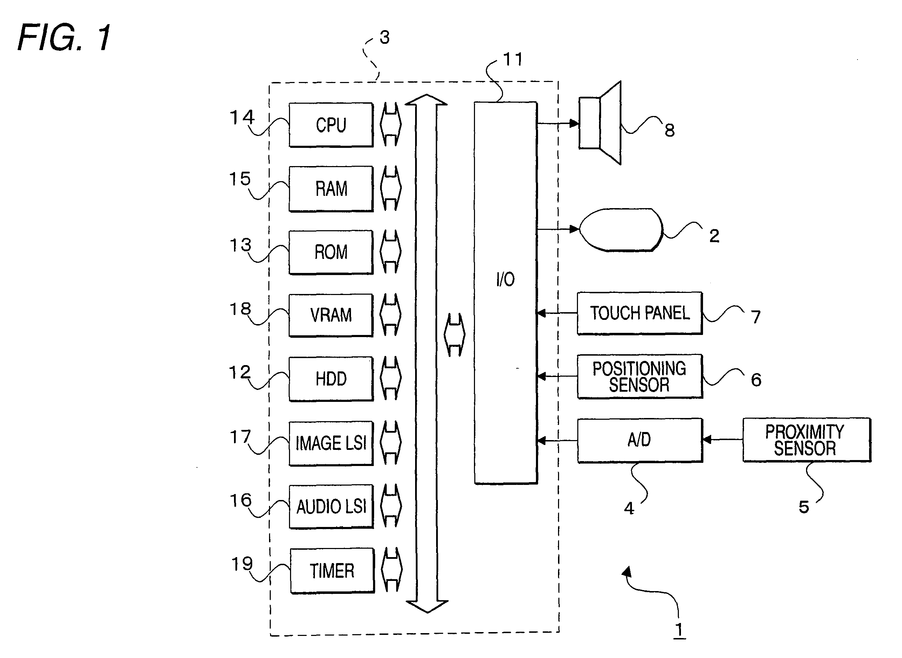

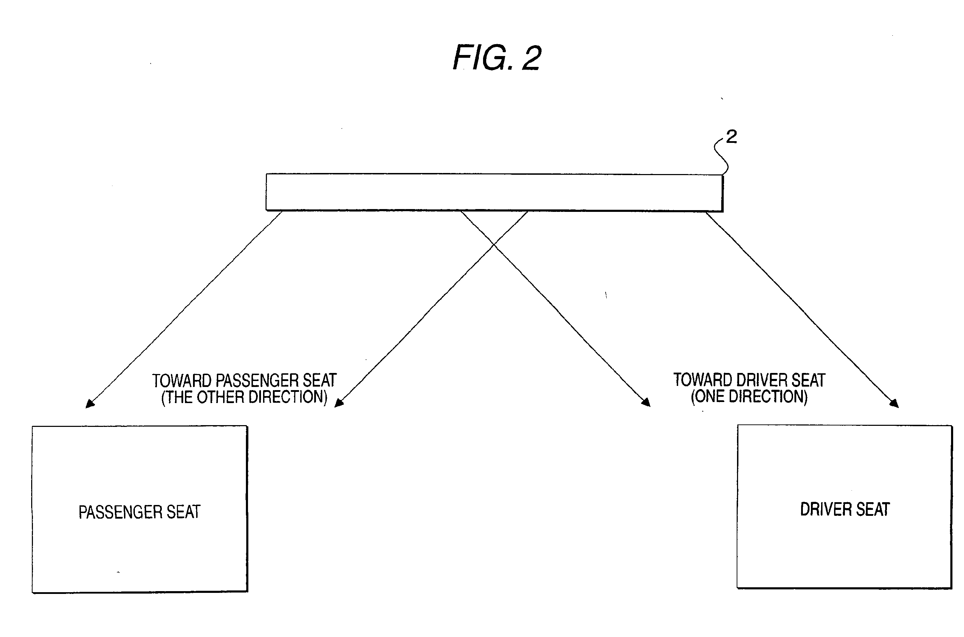

Figs. 1 through 13 show the best mode for implementing a data processing device of the present invention.
<Configuration of a navigation system 1> Fig. 1 shows the configuration of a navigation system 1 of an embodiment of the present invention. The navigation system 1 has:
a liquid-crystal display 2 (corresponding to a "display device") that displays different images to a driver seat and a passenger seat;
a navigation device 3 (corresponding to a "data processor" and a "vehicle-mounted data processing device") connected to the liquid-crystal display 2;
a proximity sensor 5 (corresponding to a "sensor") connected to the navigation device 3 by way of an A-D converter 4;
a positioning sensor 6 that outputs data corresponding to a current position;
a touch panel 7 (corresponding to a "coordinate sensor") for outputting data in response to a touch; and
a speaker 8 for outputting sound.
<Configuration of the liquid-crystal display 2> Figs. 2 through 4 show the configurations of the liquid-crystal display 2. The liquid-crystal display 2 has a first pixel group and a second pixel group. Each of the pixel groups is an aggregation of pixels made up of liquid-crystal elements and micro lenses. The liquid-crystal display 2 displays different images to a plurality of directions (see JP-A-8-136909). In the present embodiment, the liquid-crystal display 2 simultaneously displays one image and another image respectively to the driver seat and the passenger seat (see Fig. 2).

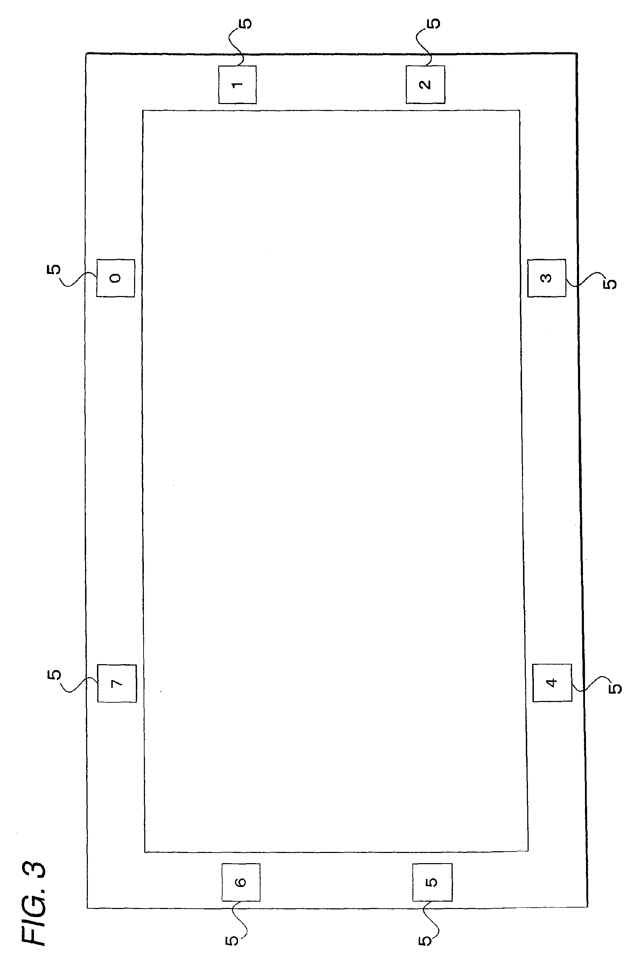

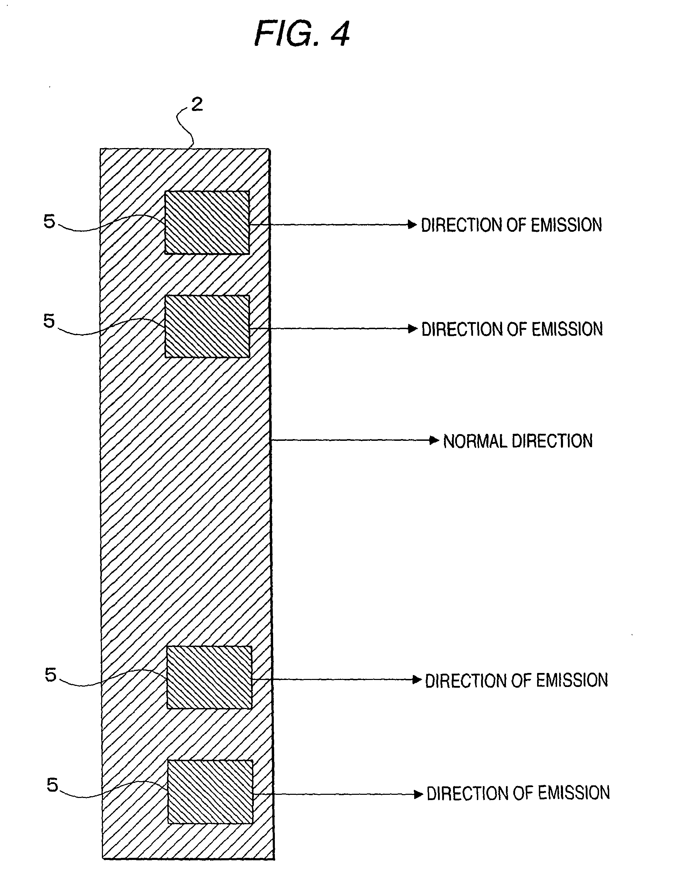

<Relationship between the liquid-crystal display 2 and the proximity sensor 5> The liquid-crystal display 2 is made up of eight proximity sensors 5 embedded along the periphery of a display area 2a. Two proximity sensors 5 are embedded along one side of the liquid-crystal display 2. A sequence in which the proximity sensors 5 are arranged is the 0^{th} to the 7^{th} in a clockwise direction (see Fig. 3). The proximity sensors 5 are provided in a state where the direction of emission of a detection medium (e.g., infrared radiation) becomes parallel to a normal direction of a display area 2a (see Fig. 4). Further, a touch panel 7 is provided on the display area 2a of the liquid-crystal display 2. Display coordinates on the liquid-crystal display 2 and operation coordinates of the touch panel 7 essentially coincide with each other. <Configuration of the navigation device 3> Fig. 1 shows the configuration of the navigation device 3. The navigation device 3 has an l/O 11 for inputting and outputting data; an HDD 12 for storing various programs and data; ROM 13 for storing a basic program, such as BIOS; a CPU 14 for executing a program stored in the HDD 12 and the ROM 13; RAM 15 for storing data processed by the CPU 14 and the like; an audio LSI 16 for processing audio data; an image LSI 17 for processing image data; VRAM 18 for holding data processed by the image LSI 17; and a timer 19 for outputting start data at a specific period. These pieces of hardware are connected with each other by way of a bus.

The proximity sensors 5 are connected to an input side of the I/O 11 by way of an A-D converter 4. Further, a positioning sensor 6 and a touch panel 7 are connected, as well. An output side of the l/O 11 is connected to a liquid-crystal display 8 and a speaker 8.

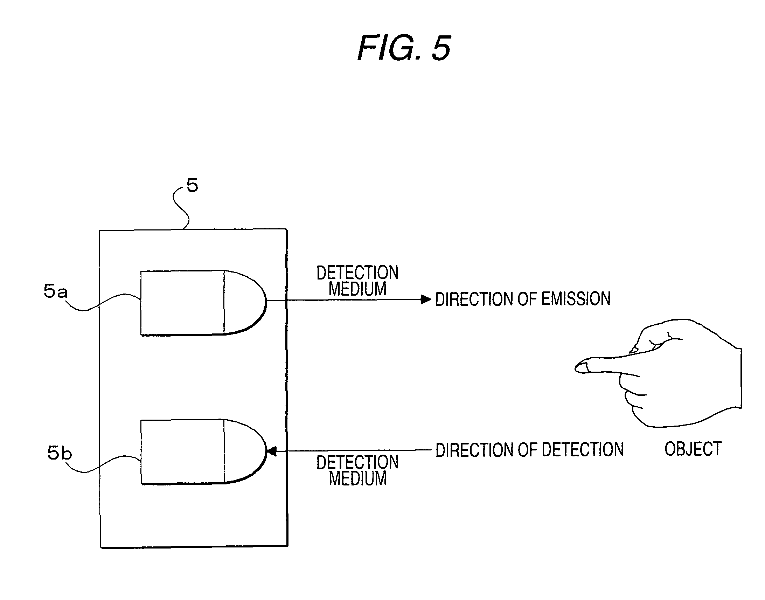

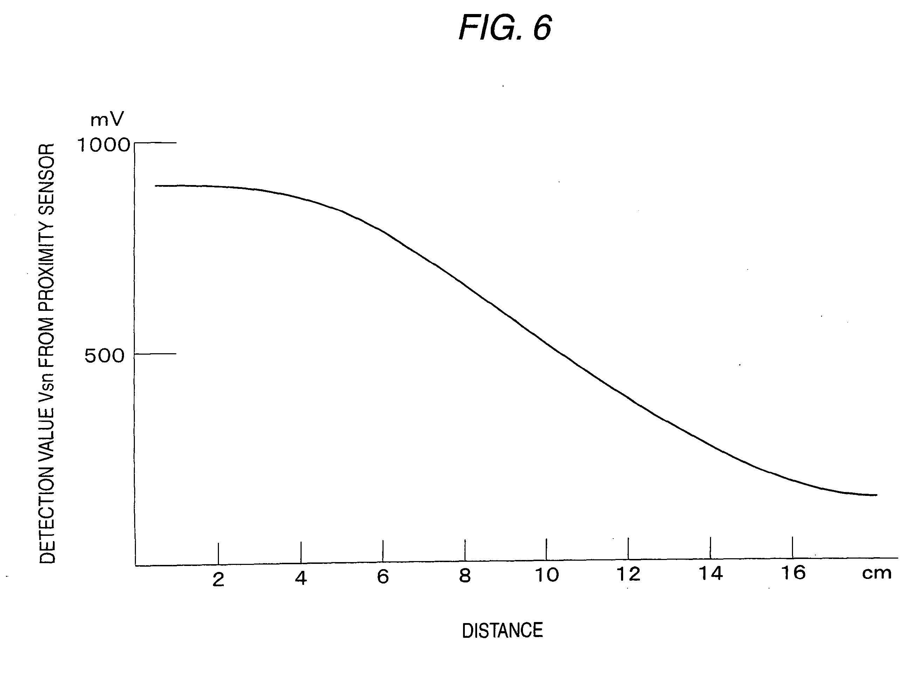

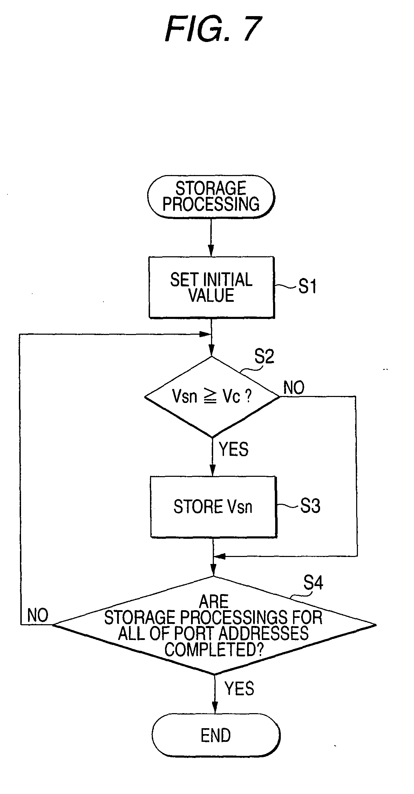

The HDD 12 stores a program run by the CPU 14 either to execute driver seat processing as processing corresponding to object presence coordinates "P(k)=(x(k),y(k))" or to execute passenger seat processing as processing corresponding to the object presence coordinates P(k). The driver seat processing is executed if the presence direction, which is determined on the basis of a detection value of the proximity sensor 5, is the direction to the driver seat. The passenger seat processing is executed if the presence direction is the direction to the passenger seat. The HDD 12 also stores a program run by the CPU 14 for controlling whether or not to display icons on the liquid-crystal display 2 depending on the detection value of the proximity sensor 5. In other words, icons for driver seat operation (driver seat icons) are displayed from the liquid-crystal display 2 to the driver seat if the presence direction, which is determined on the basis of the detection value of the proximity sensor 5, is the direction to the driver seat. Icons for passenger seat operation (passenger seat icons) are displayed from the liquid-crystal display 2 to the passenger seat if the presence direction is the direction to the passenger seat. Moreover, the HDD 12 stores driver seat icon data, passenger seat icon data, a driver seat operation table, a passenger seat operation table, and the like.
<Configuration of the proximity sensor 5> Figs. 5 and 6 show the configuration of the proximity sensor 5. The proximity sensor 5 has an emission element 5a for emitting a detection medium and a detection element 5b for detecting the detection medium. When the object opposes the proximity sensor 5, the emission element 5a emits the detection medium, and the detection element 5b detects the detection medium reflected from the object. Detection value data (hereinafter called a "detection value") corresponding to a physical quantity of the detection medium (e.g., energy) are output (see Fig. 5). The physical quantity of the detected detection medium (e.g., energy) corresponds to a distance between the proximity sensor 5 and the object (see Fig. 6).
<Data Processing> Figs. 7 through 13 show data processing of the present embodiment. The CPU 14 expands various programs and data stored in the HDD 12 in the RAM 15, and the following processing is executed.
<Storage Processing> Fig. 7 shows storage processing. The CPU 14 periodically executes the following processing while taking the start data output from the timer 14 as an interrupt. Storage processing is processing for deeming a detection value, which is smaller than a predetermined value Vsc, to be 0, and processing is sequentially executed from a port address (n=0) of the I/O 11. The reason for this is that the proximity sensors 5 output detection values Vsn even when no object is present.

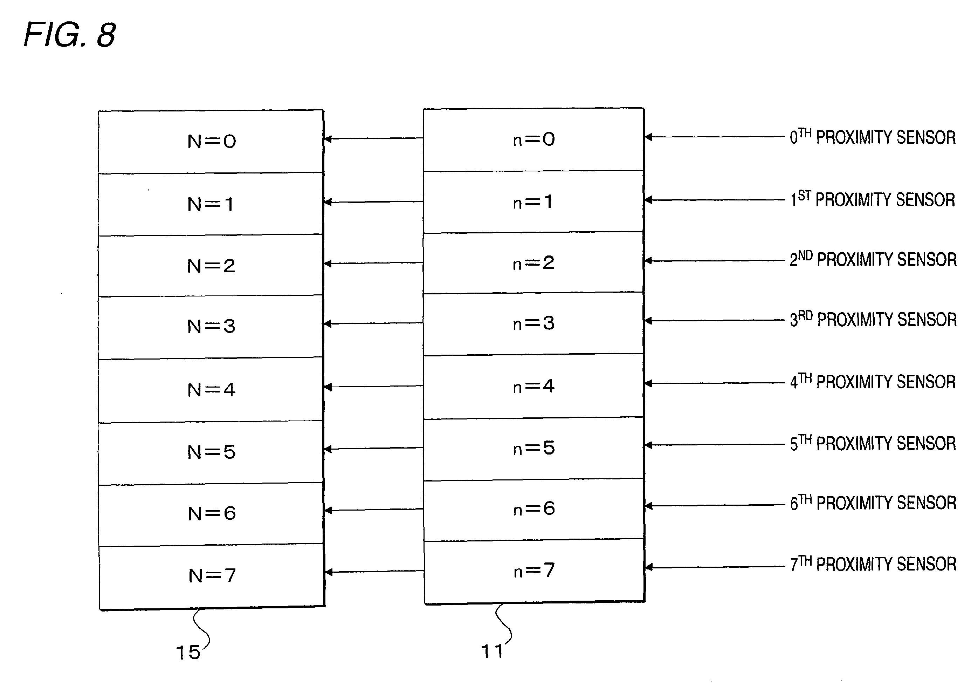

The CPU 14 initializes detection value storage areas (N=0 to 7) of the RAM 15 (step S1). Specifically, a value of "0" is stored as an initial value in the detection value storage areas (N=0 to 7) (see Fig. 8).

When initialization is executed in step S1, the CPU 14 determines whether or not the detection value Vsn is a predetermined value Vsc or more (step S2). Specifically, the detection values Vsn output from the (the 0^{th} to 7^{th}) proximity sensors 5 are input respectively to the port addresses (n=0 to 7) of the l/O 11 (see Fig. 8), and the respective detection values Vsn and the predetermined value Vsc are compared with each other. In the present embodiment, Vsc=160 mv is used.

When the detection value Vsn is determined to be the predetermined value Vsc or more in step S2 (Yes in S2), the CPU 14 stores the detection value Vsn in the RAM 15 (step S3). Specifically, the detection value Vsn input to the n^{th} port address is stored in the N^{th} detection value storage area (N) of the RAM 15. At this time, a count value of one is added to the number of storage operations stored in the RAM 15. Now, the number of storage operations is the number of times the detection value Vsn is stored in the detection value storage area (N) of the RAM 15.

In the meantime, when the detection value Vsn is determined not to be the predetermined value Vsc or more in step S21 (No in S2), the detection value Vsn is not stored in the RAM 15, and the initial value of "0" is maintained.

When processing pertaining to steps S2 and S3 is executed in connection with one port address, the CPU 14 determines whether or not storage processing is executed in connection with all of the port addresses (step S4). Specifically, the number of times processing pertaining to steps S2 to S3 is executed is counted, and a determination is made as to whether or not the count value is equal to the total number of port addresses.

When storage processing is determined not to be executed in connection with all of the port addresses in step S4 (No in S4), the CPU 14 again executes processing pertaining to steps S2 and S3 by changing a port address.

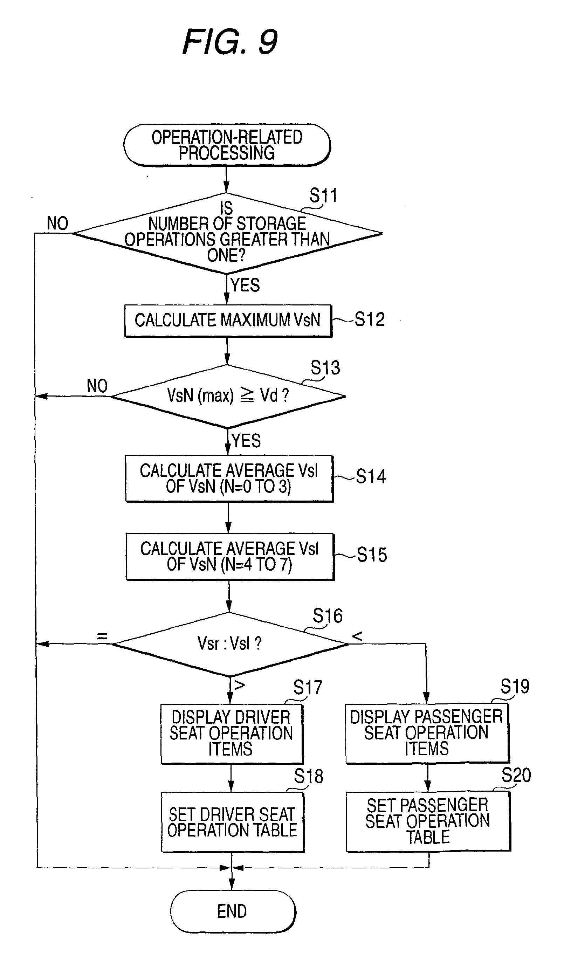

In the meantime, when storage processing is determined to be executed in connection with all of the port addresses in step S3 (YES in S4), the CPU 14 terminates storage processing.
<Operation-related processing> Operation-related processing is shown in Fig. 9. Operation-related processing is a part of ordinary processing and constitutes a loop along with other processing.

The CPU 14 determines whether or not the number of times the detection value Vsn input to the port address is stored is one or more (step S11). Specifically, reference is made to the number of times a detection value is stored in the RAM 15, whereby a determination is rendered as to whether or not the number of storage operations is zero.

When the number of storage operations is determined not to be one or more in step S11 (No in S11); namely, when the number of storage operations is determined to be zero, the CPU 14 terminates operation-related processing.

On the contrary, when the number of storage operations is determined to be one or more in step S11 (Yes in S11), the CPU 14 calculates the maximum value VsN(max) of the detection value VsN stored in the detection value storage area (step S12). Specifically, a maximum value selection technique, a quick sorting technique, and the like, is used as an algorithm.

When the maximum value VsN(max) is determined in step S12, the CPU 14 determines whether or not the maximum value VsN(max) is a predetermined value Vd or more (step S13). In the present embodiment, the predetermined value Vd is set to Vd=500 mV.

When the maximum value VsN(max) is determined not to be the predetermined value Vd or more in step S13 (No in S13), the CPU 14 terminates operation-related processing.

In the meantime, when the maximum value VsN(max) is determined to be the predetermined value Vd or more in step S6 (Yes in S13), the CPU 14 calculates an average value Vsr of the detection values VsN (N=0 to 3) (step S14). Addresses (N=0 to 7) of the RAM 15 correspond to the numbers (0 to 7) of the proximity sensors (see Fig. 8). Consequently, for example, the detection value output from the 0^{th} proximity sensor 5 or the initial value is stored in an address (N=0) of the RAM 15. Moreover, in the present embodiment, VsN (N=0 to 3) are detection values used for detecting approaching of an object from the direction to the driver seat.

When the average value Vsr is calculated in step S14, the CPU 14 calculates an average value Vsl of the detection values VsN (N=4 to 7) (step S15). In the present embodiment, VsN (N=4 to 7) are detection values used for detecting approaching of an object from the direction to the passenger seat.

When the average value Vsl is calculated in step S15, the CPU 14 compares the average value Vsr acquired in step S14 with the average value Vsl acquired in step S15 (step S16).

When a result of Vsr=Vsl is acquired in step S16 ("=" in S16), the CPU 14 terminates operation-related processing. The reason for this is that Vsr=Vsl means that no operation is executed.

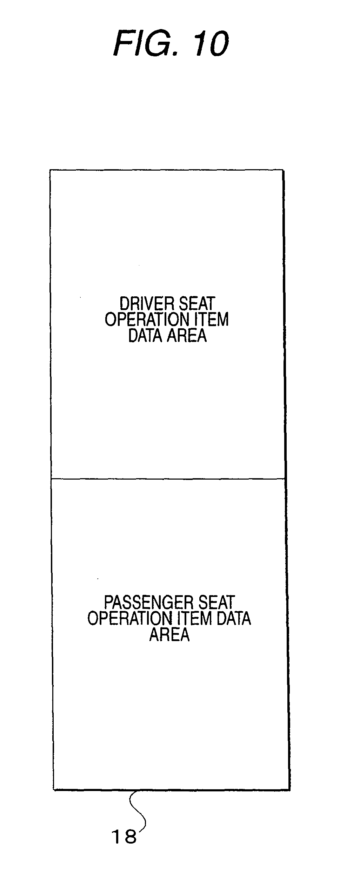

When a result of Vsr>Vsl is acquired in step S16 (">" in step S16), the CPU 14 outputs to the liquid-crystal display 2 control data for displaying driver seat operation items to the driver seat (step S17). "Vsr>Vsl" means that the presence direction of an object is the direction to the driver seat. At this time, the image LSI 17 expands driver seat operation item data stored in the HDD 12 into a driver seat area in the VRAM 18 in accordance with the control data from the CPU 14 (see Fig. 10), and outputs the driver seat operation item data expanded in the VRAM 18 to the liquid-crystal display 2.

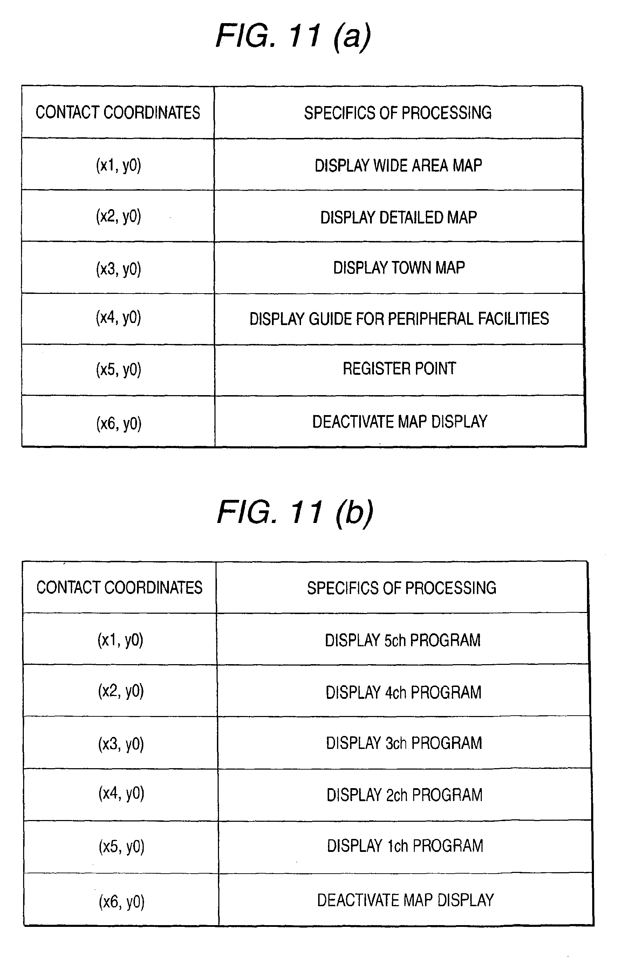

When the driver seat operation items are displayed in step S17, the CPU 14 sets the driver seat operation table (see Fig. 11A) in the area of the RAM 15 (step S18). At this time, the CPU 14 applies to the driver seat operation table the coordinate values output by means of the touch panel 7, thereby determining specifics of processing.

In the meantime, when a result of "Vsr<Vsl" is acquired in step S16 ("<" in S16), the CPU 14 outputs to the liquid-crystal display 2 control data for displaying driver seat operation items to the driver seat (step S19). "Vsr<Vsl" means that the presence direction of the object is the direction to the passenger seat. At this time, the image LSI 17 expands passenger seat operation item data stored in the HDD 12 into a passenger seat area in the VRAM 18 in accordance with the control data from the CPU 14 (see Fig. 10), and outputs the passenger seat operation items expanded in the VRAM 18 to the liquid-crystal display 2.

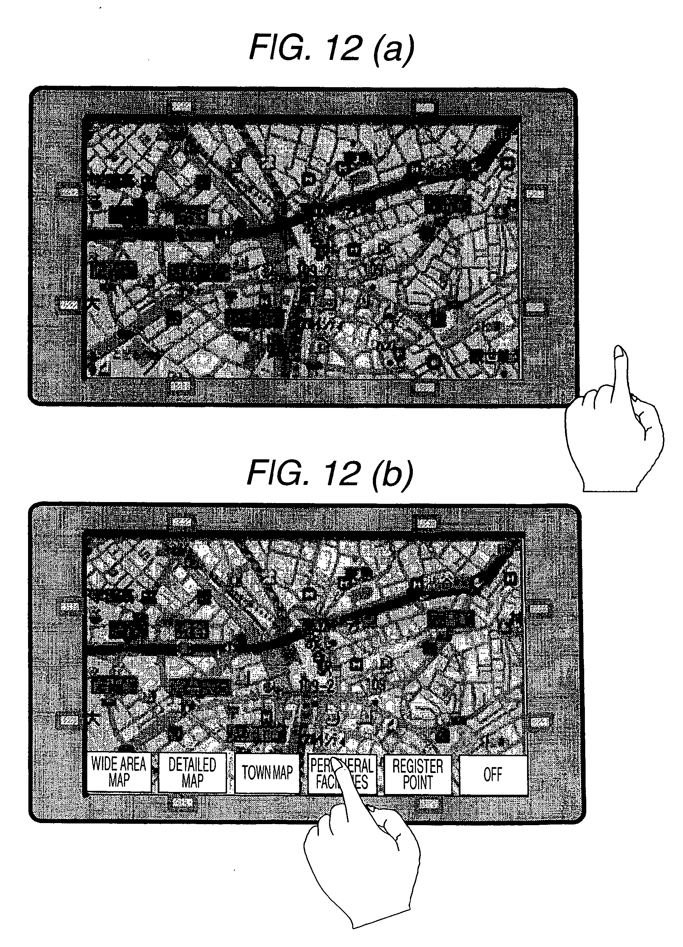

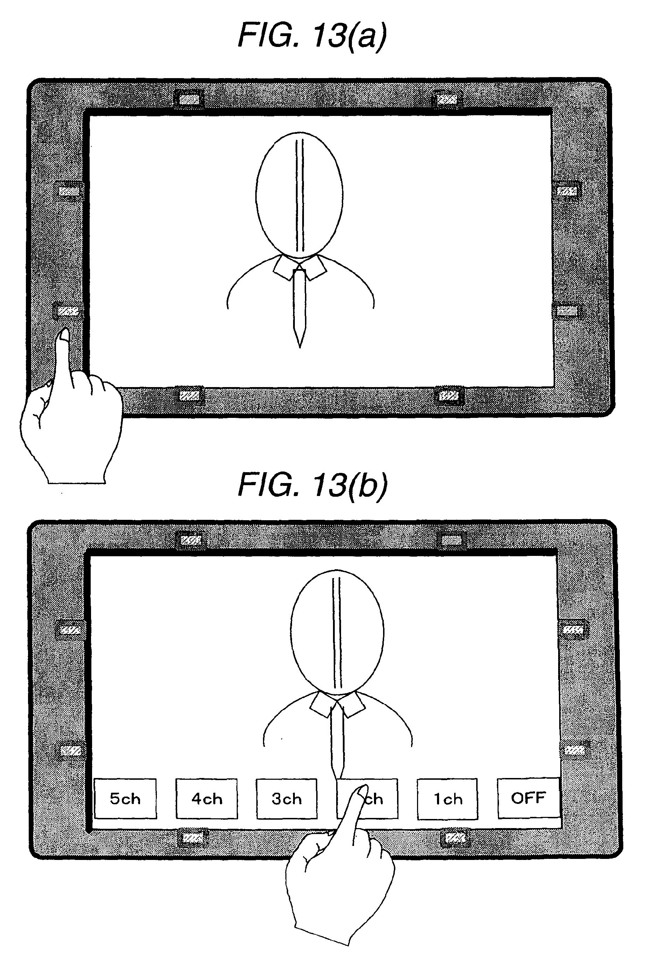

When passenger seat operation items are displayed in step S19, the CPU 14 sets a passenger seat operation table (see Fig. 11B) in the area of the RAM 15 (step S20). At this time, the CPU 14 applies to a passenger seat operation table the coordinate values output by means of the touch panel 7, thereby determining specifics of processing.
<Example Displays> Figs. 12 and 13 show example displays of the present embodiment. When an object, such as a finger, approaches the liquid-crystal display 2 from the direction to the driver seat (see Fig. 12A), operation items relating to a map menu are displayed (see Fig. 12B). On the contrary, when the object approaches the liquid-crystal display 2 from the direction to the passenger seat (see Fig. 13A), operation items relating to a TV menu are displayed (see Fig. 13B).
<Example Operations> Figs. 11 through 13 show operation examples of the present embodiment. When operation items are not displayed and when an object, such as a finger, approaches the liquid-crystal display 2 from the direction to the driver seat (see Fig. 12A), the driver seat operation table is set. Consequently, so long as the object touches coordinates (x4, y0) on the touch panel 7 (see Fig. 12B), displaying of peripheral facilities is executed (see Fig. 11A). On the other hand, when the object approaches the liquid-crystal display 2 from the direction to the passenger seat (see Fig. 13A), a passenger seat operation table is set. Therefore, displaying of the second program is executed (see Fig. 11B), so long as the object contacts the coordinates (x4, y0) on the touch panel 7 (see Figs. 13B).
<Advantage yielded by the present embodiment> According to the embodiment, the proximity sensors 5 are embedded along the periphery of the display area of the liquid-crystal display 2, and the presence direction of an object approaching the liquid-crystal display 2 is determined by use of detection values from the proximity sensors 5. Consequently, a determination is made as to whether a contact on the coordinates (x(k), y(k)) on the touch panel 7 is executed by the user in the driver seat or the user in the passenger seat, without involvement of rotation of the liquid-crystal display 2. Operations executed by the user in the driver seat and the user in the passenger seat can be distinguished from each other while the respective users are caused to visually ascertain different images.

According to the present embodiment, the driver seat operation items are displayed only to the driver seat on condition of approaching of an object, so long as the object is approaching to the liquid-crystal display 2 from the direction to the driver seat. In the meantime, the passenger seat operation items are displayed only to the passenger seat on condition of approaching of the object, so long as the object is approaching to the liquid-crystal display 2 from the direction to the passenger seat. Therefore, the user in the driver seat and the user in the passenger seat can be provided with images that do not include operation items.
<First Modification> In the present embodiment, the touch panel 7 is used. However, the present invention is practicable even when an infrared sensor, a noncontact sensor, and the like, is used instead.
<Second Modification> In the present embodiment, the direction of emission of the detection medium from the proximity sensors 5 is parallel to the normal direction of the display area 2a. However, the present invention is practicable even when the direction of emission of the detection medium from the proximity sensors 5 is perpendicular to the normal direction of the display area 2a.
<Third Modification> In the present embodiment, the proximity sensors 5 output numerals as detection values. However, the present invention is also practicable even when a sensor that outputs a logic value (e.g., a binary value showing on or off) is employed. Processing for determining the presence direction of an object is as follows. Logical values of respective sensors are held in the RAM 15 in a time-series sequence, and the presence direction of an object is determined by a sequence in which the sensors are turned on (or off). For example, in a case where the layout of the sensors is the same as that employed in the present embodiment, when the 7^{th} sensor is turned on after activation of the 0^{th} sensor, the presence direction of an object is determined to be the direction to the driver seat. In contrast, when the 0^{th} sensor is turned on after activation of the 7^{th}sensor, the presence direction of the object is determined to be the direction to the passenger seat.

### Industrial Applicability

As mentioned above, the present invention yields an advantage of the ability to distinguish operations executed by a plurality of users from each other while the users are caused to visually ascertain different images, and the present invention is useful as an audiovisual apparatus, a navigation device, and the like.

## Claims

1. A vehicle-mounted data processing device connected to a display device for displaying different images to a driver seat and a passenger seat and to a coordinate sensor for outputting a detection value corresponding to a presence coordinate of an object on a display area of the display device, the processing device comprising:
a control section which executes a driver seat processing depending on a detection value output from the coordinate sensor when a presence direction of an object is a direction to the driver seat, and executes a passenger seat processing depending on the detection value output from the coordinate sensor when the presence direction of the object is a direction to the passenger seat, wherein the presence direction of the object is determined based on the detection value of the sensor which is placed around the display area.

2. The vehicle-mounted data processing device according to claim 1, wherein the control section executes the driver seat processing as a processing corresponding to a presence coordinate P(k) of the object when the presence direction of the object is the direction to the driver seat, and executes the passenger seat processing as the processing corresponding to the presence coordinate P(k) of the object when the presence direction of the object is the direction to the passenger seat.

3. A data processing device connected to a display device for displaying different images in a first direction and in a second direction and to a coordinate sensor for outputting a detection value corresponding to a presence coordinate of an object on a display area of the display device, the processing device comprising:
a control section which executes a first direction processing depended on the detection value of the coordinate sensor when a presence direction of the object is the first direction, and executes the second direction processing depending on the detection value of the coordinate sensor when the presence direction of the object is the second direction, wherein the presence direction of the object is determined based on the detection value of the sensor which is placed around the display area.

4. The data processing device according to claim 3, wherein the control section executes the first direction processing as a processing corresponding to a presence coordinate P(k) of the object when the presence direction of the object is the first direction, and executes the second direction processing as the processing corresponding to the presence coordinate P(k) of the object when the presence direction of the object is the second direction.
